# EUROPÄISCHE PATENTSCHRIFT

(11) **EP 3 582 267 B1**
(45) Veröffentlichungstag und Bekanntmachung des Hinweises auf die Patenterteilung: **10.03.2021**
(21) Anmeldenummer: 19168668.2
(22) Anmeldetag: 11.04.2019
(51) Int. Cl.: H01L 31/103, H01L 31/028

(54) **UV-STRAHLUNGSSENSOR AUF BASIS VON DIAMANT**
UV RADIATION SENSOR BASED ON DIAMOND
CAPTEUR DE RAYONNEMENT UV À BASE DE DIAMANT

(30) Priorität: 14.06.2018 DE 102018209549
(43) Veröffentlichungstag der Anmeldung: 18.12.2019
(73) Patentinhaber: Fraunhofer-Gesellschaft zur Förderung der angewandten Forschung e.V., 80686 München (DE)
(72) Erfinder: Erlbacher, Tobias, 91058 Erlangen (DE)
(74) Vertreter: Gagel, Roland

(56) Entgegenhaltungen:
- EP-A1- 2 056 365
- JP-A- 2004 095 958
- JP-A- 2005 311 238
- JP-B2- 3 986 432
- OKANO K ET AL: "Fabrication of a diamond p-n junction diode using the chemical vapour deposition technique", SOLID STATE ELECTRONICS, ELSEVIER SCIENCE PUBLISHERS, BARKING, GB, Bd. 34, Nr. 2, 1. Februar 1991 (1991-02-01), Seiten 139-141, XP025826594, ISSN: 0038-1101, DOI: 10.1016/0038-1101(91)90079-E [gefunden am 1991-02-01]

## Beschreibung

### Technisches Anwendungsgebiet

Die vorliegende Erfindung betrifft einen UV-Strahlungssensor, der einen strahlungssensitiven Bereich aus Diamant auf einem Halbleitersubstrat aufweist.

UV-Strahlungssensoren kommen in vielen technischen Bereichen zum Einsatz. Beispiele hierfür sind die Proessüberwachung von allen Prozessen, die UV-Strahlung nutzen, oder die optische Kommunikationstechnik. Neben der hohen Sensitivität und einem geringen Signal-Rausch-Verhältnis sollen die UV-Sensoren auch eine hohe UV-Selektivität aufweisen, d.h. möglichst keine Strahlung im sichtbaren oder infraroten Spektralbereich sondern nur im UV-Bereich detektieren. Als Material für den strahlungssensitiven Bereich von UV-Strahlungssensoren bietet sich daher ein Material mit einer geeignet großen Bandlücke an, wie dies bei Diamant der Fall ist.

### Stand der Technik

Es sind bereits unterschiedliche Ausgestaltungen von UV-Strahlungssensoren bekannt, die für den strahlungssensitiven Bereich Diamant nutzen. Hierbei kann es sich sowohl um nanokristalline als auch um epitaktische Diamantschichten auf geeigneten Halbleitersubstraten handeln. Die elektrische Kontaktierung erfolgt dabei über Schottky-Kontakte und/oder Ohmsche Kontakte auf der Diamantschicht.

So beschreibt bspw. die US 7884372 B2 einen UV-Strahlungssensor, bei dem eine dotierte Diamantschicht auf einem Diamantsubstrat aufgebracht ist. Auf dieser Diamantschicht sind zwei Elektroden angeordnet, von denen eine äußere den strahlungssensitiven Bereich umschließt und einen Ohmschen Kontakt aus einem Carbid/C-haltigem Material bildet. Innerhalb des strahlungssensitiven Bereiches ist eine gleichrichtende, transsparente Elektrode aus einem Nitrid als zweite Kontaktelektrode auf der Diamantschicht angeordnet.

Die US 8435597 B2 beschreibt ebenfalls einen UV-Strahlungssensor auf Basis von Diamant. Dieser Strahlungssensor weist einen einkristallinen Diamantfilm auf einem Substrat auf, dessen Oberfläche einer speziellen Behandlung mit Ozon oder Sauerstoffatomen unterzogen wurde, wodurch die Sensitivität des Strahlungssensors bei Wellenlängen oberhalb von 220 nm eingestellt werden kann.

Die US 5 536 953 A zeigt ein Halbleiterbauteil mit einem aktiven Bereich, der eine große Bandlücke aufweist und bspw. aus Diamant gebildet sein kann.

Aus der US 2006/0118896 A1 ist ein Photodetektor mit lateralem Aufbau für kurzwelliges sichtbares Licht bekannt, der eine hohe optische Effizienz und Frequenzcharakteristik für den Wellenlängenbereich um 405 nm aufweist.

In M. Dutta et al., "Demonstration of Diamond-Based Schottky p-i-n Diode With Blocking Voltage > 500 V", IEEE Electron Device Letters, Vol. 37, No. 9, 2016, 1170-1173, ist die Herstellung einer pin-Diode auf Basis von Diamant für den Einsatz in Hochleistungsschaltern beschrieben.

Die JP 2004095958 A beschreibt einen UV-Sensor mit einem strahlungssensitiven Bereich aus Diamant, der auf einem Diamantsubstrat ausgebildet und über wenigstens zwei Kontaktelektroden elektrisch kontaktierbar ist. Der Strahlungssensor hat einen vertikalen Aufbau, bei dem der strahlungssensitive Bereich zwei übereinander liegende, unterschiedlich dotierte Bereiche aus einkristallinem Diamant aufweist, die einen pn-Übergang zur Strahlungsdetektion bilden. In einem Ausführungsbeispiel weist der obere der beiden unterschiedlich dotierten Bereiche eine Dicke von 1µm auf. Für die Dotierungskonzentrationen der oberen und unteren Bereiche bzw. Schichten werden Werte von 5×10¹⁸ cm⁻³ für die obere Schicht und 2×10¹⁷ cm⁻³ für die untere Schicht angegeben. Mit den bei diesem Strahlungssensor verwendeten Parametern wird ein Verhältnis der spektralen Sensitivität zwischen einer Wellenlänge von 200 nm und einer Wellenlänge von 250 nm von 100 oder darüber erreicht

Die JP 2005 311238 A beschreibt ebenso einen derartigen UV-Sensor. Für die Dotierungskonzentrationen der oberen und unteren Bereiche bzw. Schichten werden Werte von 10¹⁹ cm⁻³ für die obere Schicht und 17 -3 10 cm für die untere Schicht angegeben.

Die Aufgabe der vorliegenden Erfindung besteht darin, einen UV-Strahlungssensor anzugeben, der eine möglichst hohe Sensitivität im Bereich von Wellenlängen ≤ 220 nm (UV-C, Vakuum UV) gegenüber dem Wellenlängenbereich > 220 nm aufweist und damit eine störungsfreie Detektion der UV-Strahlung ermöglicht.

### Darstellung der Erfindung

Die Aufgabe wird mit dem UV-Strahlungssensor gemäß Patentanspruch 1 gelöst. Vorteilhafte Ausgestaltungen des Strahlungssensors sind Gegenstand der abhängigen Patentansprüche oder lassen sich der nachfolgenden Beschreibung sowie den Ausführungsbeispielen entnehmen.

Der vorgeschlagene UV-Strahlungssensor weist einen strahlungssensitiven Bereich aus Diamant auf, der auf einer ersten Seite eines Halbleitersubstrats ausgebildet und über wenigstens zwei Kontaktelektroden elektrisch kontaktierbar ist. Der Strahlungssensor zeichnet sich durch einen vertikalen Aufbau aus, bei dem der strahlungssensitive Bereich zwei übereinander liegende, unterschiedlich dotierte Bereiche aus einkristallinem Diamant aufweist, die einen pn-Übergang zur Strahlungsdetektion bilden, wobei die Dicke des oberen der beiden unterschiedlich dotierten Bereiche ≤ 300nm beträgt.

Der vorgeschlagene UV-Strahlungssensor weist einen pn-Übergang in dem strahlungssensitiven Bereich aus einkristallinem Diamant auf, der für die Strahlungsdetektion genutzt wird. Durch diese Ausgestaltung werden elektrische Leckströme bei der Detektion vermieden oder zumindest reduziert, wie sie bei Strahlungssensoren mit Schottky-Kontakten auftreten, und damit eine höhere Sensitivität erreicht. Insbesondere lässt sich mit dem vorgeschlagenen Strahlungssensor ein Verhältnis der spektralen Sensitivität zwischen einer Wellenlänge von 200 nm und einer Wellenlänge von 240 nm erreichen, die im Bereich von 1:1000 liegt.

Der Strahlungssensor kann dazu in unterschiedlicher Weise aufgebaut sein. In den bevorzugten Ausgestaltungen wird ein vertikaler Aufbau realisiert, bei dem die elektrische Kontaktierung durch geeignete Metallisierungen an einer Vorderseite (erste Seite) und Rückseite (zweite Seite) des Halbleitersubstrats mit dem darauf angeordneten strahlungssensitiven Bereich erfolgt.

In einer ersten Alternative ist der strahlungssensitive Bereich durch eine Schichtfolge aus einer ersten epitaktisch gewachsenen Diamantschicht eines ersten Dotierungstyps und einer zweiten epitaktisch gewachsenen Diamantschicht eines zweiten Dotierungstyps auf dem Halbleitersubstrat gebildet. Diese Schichtfolge aus den beiden Diamantschichten unterschiedlichen Dotierungstyps bildet somit den pn-Übergang des strahlungssensitiven Bereiches.

In einer zweiten Alternative ist der strahlungssensitive Bereich durch eine erste epitaktisch gewachsene Diamantschicht eines ersten Dotierungstyps auf dem Halbleitersubstrat und einen lokal dotierten Bereich eines zweiten Dotierungstyps in dieser ersten Diamantschicht gebildet. Auch hier wird der pn-Übergang des strahlungssensitiven Bereichs durch die aneinander grenzenden Bereiche mit den beiden unterschiedlichen Dotierungstypen gebildet. Es kann sich bei dem lokal dotierten Bereich des zweiten Dotierungstyps um einen in die erste Diamantschicht implantierten Bereich handeln. Alternativ kann der lokal dotierte Bereich des zweiten Dotierungstyps auch durch Anwendung eines metallkatalytischen Ätzverfahrens und epitaktisches Überwachsen des geätzten Bereiches mit der entsprechenden Dotierung hergestellt werden. Durch das metallkatalytische Ätzverfahren wird hierbei eine Wanne mit <111> orientierten Seitenflächen aus der ersten Diamantschicht herausgeätzt, die durch das eptiaktische Überwachsen anschließend wieder aufgefüllt wird.

Bei beiden Alternativen beträgt die Dotierung der ersten epitaktischen Diamantschicht < 1*10¹⁶ cm⁻³, die Dotierung der zweiten epitaktischen Diamantschicht bzw. des lokal dotierten Bereiches in der ersten epitaktischen Diamantschicht > 1*10¹⁸ cm⁻³. Die Dicke der zweiten epitaktischen Diamantschicht bzw. des lokal dotierten Bereiches des zweiten Dotierungstyps beträgt ≤ 300 nm. Mit derartigen Werten lassen sich eine hohe Sensitivität und eine hohe Selektivität des UV-Strahlungssensors für Wellenlängen ≤ 220 nm erhalten.

Das Halbleitersubstrat besteht beim vorgeschlagenen UV-Strahlungssensor, insbesondere bei den bereits beschriebenen vorteilhaften Ausgestaltungen, vorzugsweise ebenfalls aus Diamant. Grundsätzlich kann das Halbleitersubstrat auch aus einem anderen Halbleitermaterial wie beispielsweise Silizium bestehen. Das Halbleitersubstrat weist vorzugsweise eine hohe Dotierung des ersten Dotierungstyps auf und trägt eine ganzflächige Metallisierung auf der Rückseite, d.h. einer der ersten Seite gegenüber liegenden zweiten Seite des Halbleitersubstrats. Diese Metallisierung dient dann als eine der Kontaktelektroden für den strahlungssensitiven Bereich. Die Dotierung des Halbleitersubstrats ist dabei derart hoch gewählt, dass die elektrische Kontaktierung des strahlungssensitiven Bereichs über diese Metallisierung ermöglicht wird. Auf der zweiten epitaktischen Diamantschicht bzw. dem lokal dotierten Bereich in der ersten epitaktischen Diamantschicht ist dann ebenfalls wenigstens eine lokale Metallisierung aufgebracht, durch die die zweite Kontaktelektrode für den strahlungssensitiven Bereich gebildet wird.

Als erster Dotierungstyp wird bei dem vorgeschlagenen UV-Strahlungssensor vorzugsweise eine p-Dotierung, bevorzugt mit dem Dotierstoff Bor, und als zweiter Dotierungstyp eine n-Dotierung, bevorzugt mit dem Dotierstoff Phosphor, eingesetzt. Als hochdotiertes Halbleitersubstrat kann dann beispielsweise ein kommerziell erhältliches HPHT-Diamant-Substrat eingesetzt werden, wie es mit einer Dotierstoffkonzentration von 2*10²⁰ cm⁻³ kommerziell erhältlich ist.

### Kurze Beschreibung der Zeichnungen

Der vorgeschlagene UV-Strahlungssensor wird im Folgenden anhand von zwei Ausführungsbeispielen nochmals beispielhaft näher erläutert. Hierbei zeigen.
- Fig. 1: zwei beispielhafte Ausgestaltungen des vorgeschlagenen UV-Strahlungssensors mit einer Schichtfolge aus zwei epitaktischen Diamantschichten unterschiedlichen Dotierungstyps; und
- Fig. 2: zwei beispielhafte Ausgestaltungen des vorgeschlagenen UV-Strahlungssensors mit einer epitaktischen Diamantschicht eines ersten Dotierungstyps, in die ein lokal dotierter Bereich eines zweiten Dotierungstyps eingebracht ist.

### Wege zur Ausführung der Erfindung

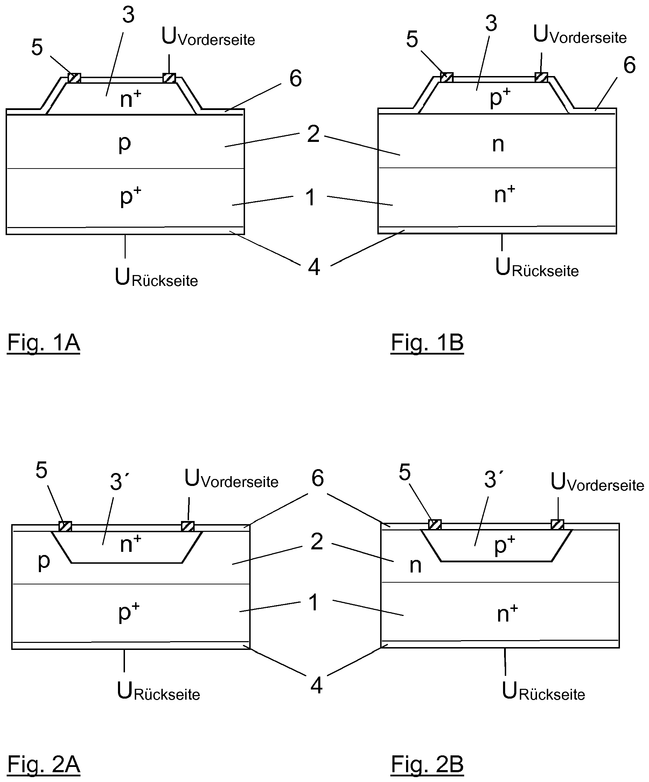

Der vorgeschlagene UV-Strahlungssensor zeichnet sich durch einen strahlungssensitiven Bereich aus einkristallinem Diamant mit einem pn-Übergang aus, der durch unterschiedlich dotierte Bereiche des Diamants gebildet ist. Figur 1A zeigt hierzu ein erstes Beispiel des vorgeschlagenen UV-Strahlungssensors. Der Strahlungssensor weist in diesem Beispiel ein p⁺-dotiertes einkristallines Diamantsubstrat 1 auf, das bspw. ein HPHT Ib (100) Diamantsubstrat sein kann. Auf dieses Diamantsubstrat 1 wird eine erste Diamantschicht 2 epitaktisch abgeschieden, die eine p-Dotierung mit einer Dotierungskonzentration von in diesem Beispiel 10¹⁵ cm⁻³ aufweist. Die Schichtdicke der ersten Diamantschicht 2 kann dabei einen großen Bereich einnehmen, bspw. zwischen 300 nm und 100 µm und beträgt vorzugsweise 1 bis 10 µm. Auf dieser ersten Diamantschicht 2 ist eine zweite Diamantschicht 3 epitaktisch abgeschieden, die eine hohe n-Dotierung von >10¹⁸ cm⁻³ und eine Dicke von ≤ 300 nm aufweist. Das Verhältnis der Dotierungskonzentrationen zwischen der ersten und der zweiten epitaktischen Diamantschicht beträgt vorzugsweise zwischen 1:500 und 1:5000, insbesondere 1:1000.

Die zweite epitaktische Diamantschicht 3 wird vorzugsweise lateral strukturiert, bspw. durch trockenchemisches Ätzen, wie dies im Ergebnis aus der Figur 1A ersichtlich ist. Weiterhin kann auf der Oberseite dieser Schichtfolge aus erster und zweiter Diamantschicht 2, 3 eine Antireflexbeschichtung 6 aufgebracht sein, die auch als Passivierungsschicht dient und für Wellenlängen von ≤ 220 nm ausgebildet ist. Diese Antireflexbeschichtung 6 kann ggfs. bereits vor dem Strukturieren der zweiten Diamantschicht 3 aufgebracht werden.

Auf die zweite Diamantschicht 3 wird schließlich noch lokal eine Kontaktmetallisierung 5 aus einem Kontaktmetall als erster elektrischer Kontakt aufgebracht. Diese Kontaktmetallisierung 5 kann bspw. aus Platin, Titan oder einer Kombination aus Gold und Titan gebildet sein. Auf die Rückseite des einkristallinen Diamantsubstrats 1 wird eine vorzugsweise ganzflächige Metallisierung 4 als zweiter elektrischer Kontakt aufgebracht.

In der Figur 1B ist eine Ausgestaltung des UV-Strahlungssensors dargestellt, die sich von der Ausgestaltung der Figur 1A nur durch die Vertauschung der Dotierungstypen unterscheidet. Der Aufbau und die Herstellung dieses UV-Strahlungssensors erfolgen in gleicher Weise wie bereits in Verbindung mit Figur 1A beschrieben. Das Diamantsubstrat 1 besteht in diesem Beispiel aus einem n⁺-dotierten einkristallinen Diamant, bspw. einem HPHT IIb (100). Auf diesem Diamantsubstrat 1 ist eine erste epitaktische Diamantschicht 2 mit einer n-Dotierung von in diesem Beispiel 1*10¹⁵ cm⁻³ und auf dieser Schicht wiederum eine zweite epitaktisch gewachsene Diamantschicht 3 mit einer p⁺-Dotierung von >10¹⁸ cm⁻³ und einer Dicke von ≤ 300 nm aufgebracht. Die Kontaktmetallisierungen 4, 5 entsprechen denen der Figur 1A.

Figur 2A zeigt schließlich beispielhaft eine weitere mögliche Ausgestaltung des vorgeschlagenen UV-Strahlungssensors, bei dem im Unterschied zu der Ausgestaltung der Figur 1A nur eine erste Diamantschicht 2 epitaktisch auf dem p⁺-dotierten einkristallinen Diamantsubstrat 1 aufgebracht ist. Diese p-dotierte Diamantschicht 2 mit einer Dotierungskonzentration von in diesem Beispiel 10¹⁵ cm⁻³ weist einen lokal dotierten Bereich 3' einer n⁺-Dotierung mit einer Dotierungskonzentration von >1*10¹⁸ cm⁻³ und einer Tiefe bzw. Dicke von ≤ 300 nm auf. Vorzugsweise beträgt auch hier das Verhältnis der Dotierungskonzentrationen zwischen der ersten epitaktischen Diamantschicht 2 und dem lokal dotierten Bereich 3' zwischen 1:500 und 1:5000, insbesondere 1:1000. Die weitere Ausgestaltung dieses UV-Strahlungssensors mit der Antireflexbeschichtung 6 und den Kontaktmetallisierungen 4 bzw. 5 ist identisch der Ausgestaltung der Figur 1A.

Figur 2B zeigt wiederum eine Ausgestaltung eines derartigen UV-Strahlungssensors, bei dem gegenüber der Figur 2A in gleicher Weise wie bei Figur 1B lediglich die Dotierungstypen ausgetauscht sind.

Derartige UV-Strahlungssensoren wie sie in den Figuren 1 und 2 beispielhaft dargestellt sind, können mit einem hohen Verhältnis der spektralen Sensitivität zwischen einer Wellenlänge von 200 nm und einer Wellenlänge von 240 nm von 1:1000 hergestellt werden. Damit wird ein UV-Strahlungssensor mit entsprechend hoher Sensitivität und spektraler Selektivität ermöglicht, der sich für eine störungsfreie Detektion von Wellenlängen ≤ 220 nm eignet. Der vorgeschlagene UV-Strahlungssensor kann auch mit einem zweiten Sensor, bspw. auf Basis von Silizium, kombiniert werden, der für einen Wellenlängenbereich oberhalb von 220 nm selektiv ist. Aus den Detektionssignalen der beiden Sensoren kann dann ein Differenzsignal gebildet werden, um die spektrale Sensitivität nochmals zu erhöhen. Beide Sensoren können auch auf einem gemeinsamen Substrat realisiert werden.

### Bezugszeichenliste

- 1: Diamantsubstrat
- 2: erste Diamantschicht
- 3: zweite Diamantschicht
- 3': lokal dotierter Bereich
- 4: Rückseitenmetallisierung
- 5: Kontaktmetallisierung
- 6: Antireflexbeschichtung

## Patentansprüche

1. UV-Strahlungssensor mit einem strahlungssensitiven Bereich aus Diamant, der auf einer ersten Seite eines Halbleitersubstrats (1) ausgebildet und über wenigstens zwei Kontaktelektroden elektrisch kontaktierbar ist,
wobei der UV-Strahlungssensor einen vertikalen Aufbau aufweist, bei dem der strahlungssensitive Bereich zwei übereinander liegende, unterschiedlich dotierte Bereiche aus einkristallinem Diamant (2, 3, 3') aufweist, die einen pn-Übergang zur Strahlungsdetektion bilden,
wobei eine Dicke eines oberen der beiden unterschiedlich dotierten Bereiche ≤ 300nm beträgt,
wobei der strahlungssensitive Bereich entweder durch eine Schichtfolge einer ersten epitaktischen Diamantschicht (2) eines ersten Dotierungstyps und einer zweiten epitaktischen Diamantschicht (3) eines zweiten Dotierungstyps auf dem Halbleitersubstrat (1) oder durch eine erste epitaktische Diamantschicht (2) eines ersten Dotierungstyps auf dem Halbleitersubstrat (1) und einem in der ersten epitaktischen Diamantschicht (2) lokal dotierten Bereich (3') eines zweiten Dotierungstyps gebildet ist, und
wobei eine Dotierungskonzentration des ersten Dotierungstyps in der ersten epitaktischen Diamantschicht (2) < 1*10¹⁶ cm⁻³ beträgt und eine Dotierungskonzentration des zweiten Dotierungstyps in der zweiten epitaktischen Diamantschicht (3) oder dem lokal dotierten Bereich (3') > 1*10¹⁸ cm⁻³ beträgt.

2. UV-Strahlungssensor nach Anspruch 1,
**dadurch gekennzeichnet,**
**dass** ein Verhältnis der Dotierungskonzentrationen des ersten Dotierungstyps in der ersten epitaktischen Diamantschicht (2) und des zweiten Dotierungstyps in der zweiten epitaktischen Diamantschicht (3) oder dem lokal dotierten Bereich zwischen 1:500 und 1:5000 beträgt.

3. UV-Strahlungssensor nach Anspruch 1 oder 2,
**dadurch gekennzeichnet,**
**dass** das Halbleitersubstrat (1) eine hohe Dotierung des ersten Dotierungstyps aufweist und an einer der ersten Seite gegenüberliegenden zweiten Seite eine Metallisierung (4) trägt, die eine erste der Kontaktelektroden bildet, wobei die hohe Dotierung so gewählt ist, dass eine elektrische Kontaktierung des strahlungssensitiven Bereiches durch die erste Kontaktelektrode ermöglicht wird.

4. UV-Strahlungssensor nach Anspruch 3,
**dadurch gekennzeichnet,**
**dass** auf dem strahlungssensitiven Bereich eine lokale Metallisierung (5) aufgebracht ist, die eine zweite der Kontaktelektroden bildet.

5. UV-Strahlungssensor nach einem der Ansprüche 1 bis 4, **dadurch gekennzeichnet,**
**dass** das Halbleitersubstrat (1) ein einkristallines Diamantsubstrat ist.

6. UV-Strahlungssensor nach einem der Ansprüche 1 bis 5, **dadurch gekennzeichnet,**
**dass** auf dem strahlungssensitiven Bereich eine Antireflexbeschichtung (6) aufgebracht ist.

## Claims

1. An UV-radiation sensor with a radiation-sensitive region of diamond, which is formed on a first face of a semiconductor substrate (1) and with which electrical contact can be made via at least two contact electrodes,
wherein the UV-radiation sensor has a vertical structure in which the radiation-sensitive region comprises two differently doped, stacked regions of monocrystalline diamond (2, 3, 3') which form a pn-junction for purposes of radiation detection,
wherein an uppermost of the two differently doped regions has a thickness ≤ 300 nm,
wherein the radiation-sensitive region is formed either by a layer sequence of a first epitaxial diamond layer (2) of a first dopant type and a second epitaxial diamond layer (3) of a second dopant type on the semiconductor substrate (1) or by a layer sequence of a first epitaxial diamond layer (2) of a first dopant type on the semiconductor substrate (1) and a region (3') of a second dopant type doped locally in the first epitaxial diamond layer (2), and
wherein a doping concentration of the first dopant type in the first epitaxial diamond layer (2) is < 1*10¹⁶ cm⁻³, and a doping concentration of the second dopant type in the second epitaxial diamond layer (3) or the locally doped region (3') is > 1*10¹⁸ cm⁻³.

2. The UV-radiation sensor according to Claim 1,
**characterized in**
**that** a ratio of the dopant concentrations of the first dopant type in the first epitaxial diamond layer (2) and the second dopant type in the second epitaxial diamond layer (3) or the locally doped region is between 1:500 and 1:5000.

3. The UV-radiation sensor according to Claim 1 or 2,
**characterized in**
**that** the semiconductor substrate (1) has a high level of doping of the first dopant type, and on a second face opposite the first face supports a metallisation (4) which forms a first of the contact electrodes, wherein the high level of doping is selected such that electrical contact with the radiation-sensitive region by the first contact electrode is made possible.

4. The UV-radiation sensor according to Claim 3,
**characterized in**
**that** a local metallisation (5), which forms a second of the contact electrodes, is applied to the radiation-sensitive region.

5. The UV-radiation sensor according to any one of Claims 1 to 4,
**characterized in**
**that** the semiconductor substrate (1) is a monocrystalline diamond substrate.

6. The UV-radiation sensor according to any one of Claims 1 to 5,
**characterized in that**
an anti-reflection coating (6) is applied to the radiation-sensitive region.

## Revendications

1. Capteur de rayonnement UV comportant une zone sensible aux rayonnements en diamant, qui est formée sur un premier côté d'un substrat semi-conducteur (1) et peut être contacté électriquement via au moins deux électrodes de contact,
dans lequel le capteur de rayonnement UV présente une structure verticale, dans laquelle la zone sensible aux rayonnements présente deux zones superposée, dopées différemment constituées d'un diamant monocristallin (2, 3, 3'), qui forment une jonction pn pour la détection de rayonnement,
dans lequel une épaisseur d'une partie supérieure des deux régions dopées différemment s'élève à ≤ 300nm,
dans lequel la zone sensible aux rayonnements est formée soit par une succession de couches d'une première couche de diamant épitaxial (2) d'un premier type de dopage et d'une deuxième couche de diamant épitaxiale (3) d'un deuxième type de dopage sur le substrat semi-conducteur (1) ou par une première couche de diamant épitaxiale (2) d'un premier type de dopage sur le substrat semi-conducteur (1) et une région localement dopée (3') d'un second type de dopage dans la première couche de diamant épitaxiale (2), et
dans lequel une concentration de dopage du premier type de dopage dans la première couche de diamant épitaxiale (2) s'élève à < 1*10¹⁶ cm⁻³ et une concentration de dopage du deuxième type de dopage dans la deuxième couche de diamant épitaxiale (3) ou dans la zone dopée localement (3') s'élève à > 1*10¹⁸ cm⁻³.

2. Capteur de rayonnement UV selon la revendication 1,
**caractérisé en ce**
**qu'**un rapport des concentrations de dopage du premier type de dopage dans la première couche de diamant épitaxiale (2) et du deuxième type de dopage dans la deuxième couche de diamant épitaxiale (3) ou la zone dopée localement est compris entre 1 : 500 et 1 : 5000.

3. Capteur de rayonnement UV selon la revendication 1 ou 2,
**caractérisé en ce**
**que** le substrat semi-conducteur (1) présente un dopage élevé du premier type de dopage et sur un deuxième côté opposé au premier côté porte une métallisation (4) qui forme une première des électrodes de contact, le dopage élevé étant choisi de telle sorte que contact électrique de la zone sensibles aux rayonnements soit rendu possible par la première électrode de contact.

4. Capteur de rayonnement UV selon la revendication 3,
**caractérisé en ce**
**qu'**une métallisation locale (5) qui forme une deuxième des électrodes de contact est appliquée sur la zone sensible au rayonnement.

5. Capteur de rayonnement UV selon une des revendications 1 à 4,
**caractérisé en ce**
**que** le substrat semi-conducteur (1) est un substrat en diamant monocristallin.

6. Capteur de rayonnement UV selon une des revendications 1 à 5,
**caractérisé en ce**
**qu'**un revêtement antireflet (6) est appliqué sur la zone sensible aux rayonnements.
